# EUROPEAN PATENT APPLICATION

(11) **EP 4 761 498 A1**
(43) Date of publication of application: **17.06.2026**
(21) Application number: 24853228.5
(22) Date of filing: 11.04.2024
(51) Int. Cl.: H10B 53/30, H10N 97/00

(54) **FERROELECTRIC MEMORY CELL, MANUFACTURING METHOD THEREFOR, FERROELECTRIC MEMORY, AND ELECTRONIC DEVICE**

(30) Priority: 14.08.2023 CN 202311023318
(71) Applicant: HUAWEI TECHNOLOGIES CO., LTD., Shenzhen 518129 (CN)
(72) Inventor: TAN, Wanliang, Shenzhen, Guangdong 518129 (CN); LI, Yuxing, Shenzhen, Guangdong 518129 (CN); YOU, Yunfeng, Shenzhen, Guangdong 518129 (CN); ZENG, Sheng, Shenzhen, Guangdong 518129 (CN); XU, Jeffrey Junhao, Shenzhen, Guangdong 518129 (CN)
(74) Representative: Maiwald GmbH
(86) International application number: PCT/CN2024/087323
(87) International publication number: WO 2025/035812

(57) **Abstract**

Provided are a ferroelectric memory cell and a preparation method therefor, a ferroelectric memory (100), and an electronic device. The ferroelectric memory cell includes: a first electrode (10), a composite electrode (20), and a ferroelectric storage layer (30) disposed between the first electrode (10) and the composite electrode (20). The composite electrode (20) includes a conductive buffer layer (21), a conductive oxygen scavenger layer (22), and a second electrode (23). Gibs of an oxide corresponding to the conductive oxygen scavenger layer (22) is less than Gibs of an oxide corresponding to the first electrode (10). In this way, the conductive oxygen scavenger layer (22) can scavenge oxygen in an oxide layer (m0) formed between the first electrode (10) and the ferroelectric storage layer (30), reducing an amount of oxygen in the oxide layer (m0), reducing a thickness of the oxide layer (m0), and suppressing further formation of the oxide layer (m0), to reduce retention loss and weaken imprint effect, thereby improving performance of the ferroelectric memory cell. In addition, the conductive buffer layer (21) can avoid direct contact between the conductive oxygen scavenger layer (22) and the ferroelectric storage layer (30), thereby avoiding failure or reduction of scavenging of oxygen in the oxide layer (m0).

## Description

### CROSS-REFERENCE TO RELATED APPLICATIONS

This application claims priority to Chinese Patent Application No. 202311023318.7, filed with the China National Intellectual Property Administration on August 14, 2023 and entitled "FERROELECTRIC MEMORY CELL AND PREPARATION METHOD THEREFOR, FERROELECTRIC MEMORY, AND ELECTRONIC DEVICE", which is incorporated herein by reference in its entirety.

### TECHNICAL FIELD

This application relates to the field of storage technologies, and in particular, to a ferroelectric memory cell and a preparation method therefor, a ferroelectric memory, and an electronic device.

### BACKGROUND

A ferroelectric memory offers advantages such as low read and write voltages, low power consumption, small component size, high read and write speeds, good cycle performance, and good radiation resistance and non-volatility, making it promising for construction of next-generation non-volatile memories. Compared with a conventional ferroelectric material, a hafnium-based ferroelectric material exhibits an excellent scaling-down characteristic, and can overcome technical challenges and bottlenecks of the conventional ferroelectric material, such as incompatibility with a complementary metal oxide semiconductor (Complementary Metal Oxide Semiconductor, CMOS) process, difficulty in scaling down, and difficulty in implementing high-density integration. Therefore, a hafnium-based ferroelectric component has potential to become a core unit for a new ferroelectric memory in the future.

However, the ferroelectric memory still has some problems, such as retention loss and imprint effect. The retention means a capability of maintaining a specific polarization state. The retention loss causes polarization intensity to decrease over time. This means that data stored in a ferroelectric memory cell becomes unclear over time, making it difficult to read accurately. The imprint effect indicates a tendency of ferroelectric polarization to a specific direction, and for a polarization loop, shows a left shift or a right shift of a ferroelectric hysteresis loop. This makes a storage state (for example, storing data "1") of a ferroelectric memory cell more apparent, while makes another storage state (correspondingly, storing data "0") difficult to recognize, leading to misreading. Therefore, it is urgent for the ferroelectric memory to reduce the retention loss and weaken the imprint effect.

### SUMMARY

This application provides a ferroelectric memory cell and a preparation method therefor, a ferroelectric memory, and an electronic device, to reduce retention loss in the ferroelectric memory, weaken imprint effect, and improve performance of the ferroelectric memory.

According to a first aspect, an embodiment of this application provides a ferroelectric memory cell. The ferroelectric memory cell may include: a first electrode, a composite electrode, and a ferroelectric storage layer disposed between the first electrode and the composite electrode, where the composite electrode includes a conductive buffer layer, a conductive oxygen scavenger layer, and a second electrode that are sequentially disposed in a direction from the first electrode to the ferroelectric storage layer, where Gibbs free energy (Gibs for short) of an oxide corresponding to the conductive oxygen scavenger layer is less than Gibs of an oxide corresponding to the first electrode, so that a capability of the conductive oxygen scavenger layer for scavenging oxygen is higher than a capability of the first electrode for scavenging oxygen. In this way, the conductive oxygen scavenger layer can scavenge oxygen in an oxide layer formed between the first electrode and the ferroelectric storage layer. In addition, an oxygen vacancy in the ferroelectric storage layer can be used as a transport channel for oxygen, to transport oxygen from the oxide layer located between the first electrode and the ferroelectric storage layer to the conductive oxygen scavenger layer. In this way, an amount of oxygen in the oxide layer between the first electrode and the ferroelectric storage layer can be reduced, so that a thickness of the oxide layer can be reduced, and further formation of the oxide layer can be suppressed. Because the oxide layer weakens retention and imprint effect, thinning the oxide layer can avoid deterioration of the retention, thereby reducing retention loss, and can further weaken the imprint effect, thereby improving performance of the ferroelectric memory cell. In addition, the conductive buffer layer can avoid direct contact between the conductive oxygen scavenger layer and the ferroelectric storage layer, so that scavenging of oxygen in the ferroelectric storage layer by the conductive oxygen scavenger layer during direct contact is avoided, thereby avoiding failure or reduction of scavenging of oxygen in the oxide layer.

Further, because the conductive oxygen scavenger layer can scavenge oxygen in the oxide layer between the first electrode and the ferroelectric storage layer, and the oxygen vacancy in the ferroelectric storage layer can be used as a transport channel for oxygen, oxygen vacancies in the ferroelectric storage layer migrate to the oxide, adjusting a distribution gradient of the oxygen vacancies in the ferroelectric storage layer. In this case, density of the oxygen vacancies in the ferroelectric storage layer gradually increases in a direction from the composite electrode to the first electrode. In this way, further formation of the oxide layer between the first electrode and the ferroelectric storage layer can also be suppressed. Certainly, the first electrode can achieve specific chemical decomposition effect on the oxide layer. This effect can also suppress further formation of the oxide layer, thereby further improving performance of the ferroelectric memory cell. It should be understood that thermodynamic stability of the oxide in the ferroelectric storage layer is higher than stability of the oxide corresponding to the first electrode, so that the conductive oxygen scavenger layer is more likely to scavenge oxygen in the oxide with poor stability, and oxygen in the oxide with good stability is not scavenged or is scavenged in an extremely small amount that can be omitted.

For example, the first electrode may be made of a conductive metal, metal oxide, or metal nitride, or another material, and the first electrode may include one or more metal elements. When the first electrode includes a plurality of metals, Gibs of the oxide corresponding to the conductive oxygen scavenger layer is less than Gibs of the oxide corresponding to each metal included in the first electrode. In this way, the conductive oxygen scavenger layer can scavenge oxygen in the oxide corresponding to each metal in the first electrode, thereby reducing a thickness of the oxide between the first electrode and the ferroelectric storage layer, further improving retention and weakening imprint effect, and improving performance of the ferroelectric memory cell.

A material for preparing the conductive buffer layer may include at least one of TiN and TaN. Certainly, another material that can implement a function of the conductive buffer layer is also suitable in embodiments of this application. In addition, a thickness of the conductive buffer layer may be set to 1 nm to 20 nm. Setting the thickness of the conductive buffer layer to be in an appropriate range can avoid direct contact between the conductive oxygen scavenger layer and the ferroelectric storage layer, and can also avoid a large thickness of the entire ferroelectric memory cell, thereby avoiding an increase in a volume of the ferroelectric memory cell.

A material for preparing the conductive oxygen scavenger layer may include at least one of yttrium, titanium, lanthanum, scandium, copper, aluminum, tantalum, and hafnium. Certainly, another material that can implement the conductive oxygen scavenger layer is also suitable in embodiments of this application. In addition, a thickness of the conductive oxygen scavenger layer may be set to 0.5 nm to 5 nm. The conductive oxygen scavenger layer provided with an appropriate thickness can scavenge oxygen in the oxide layer formed between the first electrode and the ferroelectric storage layer, to reduce a thickness of the oxide layer, and can also avoid a large thickness of the entire ferroelectric memory cell, thereby avoiding an increase in a volume of the ferroelectric memory cell.

A material for preparing the second electrode includes a conductive material, and the conductive material does not include an oxygen element. In this way, the conductive oxygen scavenger layer can fully scavenge oxygen in the oxide layer between the first electrode and the ferroelectric storage layer, to maximize reduction of a thickness of the oxide layer, thereby further improving retention of the ferroelectric storage layer and weakening imprint effect, and further improving performance of the ferroelectric memory cell. In addition, under an external force, the first electrode and the second electrode can apply stress applied to the ferroelectric storage layer, to promote crystallization of a material in the ferroelectric storage layer, facilitating formation of a ferroelectric phase in the ferroelectric storage layer, thereby facilitating formation of the ferroelectric memory cell. In this case, a thickness of the first electrode may be set to 1 nm to 100 nm, and a thickness of the second electrode may be set to 30 nm to 100 nm, so that the first electrode and the second electrode can bear an external force.

The composite electrode may further include a conductive adhesion layer disposed between the conductive oxygen scavenger layer and the second electrode. The conductive adhesion layer can increase adhesion strength between the conductive oxygen scavenger layer and the second electrode, and avoid detachment of the conductive oxygen scavenger layer from the second electrode, thereby improving reliability of the ferroelectric memory cell. A material for preparing the conductive adhesion layer may include at least one of TiN and TaN. Certainly, another material that can implement a function of the conductive adhesion layer is also suitable in embodiments of this application. In addition, a thickness of the conductive adhesion layer may be set to 1 nm to 20 nm. Setting the thickness of the conductive adhesion layer to be in an appropriate range can increase adhesion strength between the conductive oxygen scavenger layer and the second electrode, and can also avoid a large thickness of the entire ferroelectric memory cell, thereby avoiding an increase in a volume of the ferroelectric memory cell.

A material for preparing the ferroelectric storage layer may be a doped hafnium oxide material. For example, the material for preparing the ferroelectric storage layer may include: zirconium-doped hafnium oxide (for example, Hf_{0.5}Zr_{0.5}O₂), zirconium- and lanthanum-doped hafnium oxide (for example, La-doped Hf_{0.3}Zr_{0.3}O₂), zirconium- and yttrium-doped hafnium oxide (for example, Y-doped Hf_{0.5}Zr_{0.5}O₂), zirconium- and strontium-doped hafnium oxide (for example, Sr-doped Hf_{0.5}Zr_{0.5}O₂), zirconium- and gadolinium-doped hafnium oxide (for example, Gd-doped Hf_{0.5}Zr_{0.5}O₂), zirconium-, gadolinium-, and lanthanum-doped hafnium oxide (for example, Gd and La co-doped Hf_{0.5}Zr_{0.5}O₂), silicon-doped hafnium oxide (for example, Si-doped HfO₂), aluminum-doped hafnium oxide, lanthanum-doped hafnium oxide, yttrium-doped hafnium oxide, gadolinium-doped hafnium oxide, strontium-doped hafnium oxide, and the like. In addition, a thickness of the ferroelectric storage layer may be set to 1 nm to 100 nm. Setting the thickness of the ferroelectric storage layer to be in an appropriate range can facilitate formation of a ferroelectric phase, avoiding failure of formation of the ferroelectric phase due to an excessively large thickness of the ferroelectric storage layer, and can also avoid a large thickness of the entire ferroelectric memory cell, thereby avoiding an increase in a volume of the ferroelectric memory cell.

For example, the ferroelectric memory cell may include a transistor and a storage capacitor. A storage solution provided in embodiments of this application may be applied to the storage capacitor, that is, the first electrode, the ferroelectric storage layer, and the composite electrode may form the storage capacitor. In addition, when the ferroelectric memory cell is disposed on a substrate, the first electrode, the ferroelectric storage layer, and the composite electrode may be stacked in a direction perpendicular to a surface of the substrate, and the ferroelectric storage layer is disposed between the first electrode and the composite electrode. In this case, the storage capacitor may be considered as a storage capacitor of a two-dimensional structure. Alternatively, the first electrode and an insulation layer may be alternately stacked in a direction perpendicular to a surface of the substrate to form a stacked structure, then a through hole is made in the stacked structure, where the through hole passes through the stacked structure in a stacking direction, and then the through hole is filled sequentially with the ferroelectric storage layer and the composite electrode, where the ferroelectric storage layer is disposed between the stacked structure and the composite electrode. In this case, a stacking direction of the conductive buffer layer, the conductive oxygen scavenger layer, and the second electrode in the composite electrode is perpendicular to an extension direction of the through hole, so that the formed storage capacitor may be considered as a storage capacitor of a three-dimensional structure.

According to a second aspect, an embodiment of this application further provides a method for preparing a ferroelectric memory cell. The ferroelectric memory cell prepared according to the preparation method may be the ferroelectric memory cell described in the first aspect and any possible implementation of the first aspect. The preparation method may include: forming the first electrode; forming the ferroelectric storage layer on the first electrode; forming the conductive buffer layer on the ferroelectric storage layer; forming the conductive oxygen scavenger layer on the conductive buffer layer, where the Gibbs free energy of the oxide corresponding to the conductive oxygen scavenger layer is less than the Gibbs free energy of the oxide corresponding to the first electrode; and forming the second electrode on the conductive oxygen scavenger layer, for the conductive buffer layer, the conductive oxygen scavenger layer, and the second electrode to form the composite electrode. In this way, the conductive oxygen scavenger layer can scavenge oxygen in an oxide layer between the first electrode and the ferroelectric storage layer. In addition, an oxygen vacancy in the ferroelectric storage layer can be used as a transport channel for oxygen, to transport oxygen from the oxide layer located between the first electrode and the ferroelectric storage layer to the conductive oxygen scavenger layer. In this way, an amount of oxygen in the oxide layer between the first electrode and the ferroelectric storage layer can be reduced, so that a thickness of the oxide layer can be reduced, and further formation of the oxide layer can be suppressed. Because the oxide layer weakens retention and imprint effect, thinning the oxide layer can avoid deterioration of the retention, thereby reducing retention loss, and can further weaken the imprint effect, thereby improving performance of the ferroelectric memory cell. In addition, the conductive buffer layer can avoid direct contact between the conductive oxygen scavenger layer and the ferroelectric storage layer, so that scavenging of oxygen in the ferroelectric storage layer by the conductive oxygen scavenger layer during direct contact is avoided, thereby avoiding failure or reduction of scavenging of oxygen in the oxide layer.

For example, when the ferroelectric memory cell further includes the conductive adhesion layer disposed between the conductive oxygen scavenger layer and the second electrode, the preparation method may further include: forming the conductive adhesion layer on the conductive oxygen scavenger layer after forming the conductive oxygen scavenger layer and before forming the second electrode. The conductive adhesion layer can increase adhesion strength between the conductive oxygen scavenger layer and the second electrode, and avoid detachment of the conductive oxygen scavenger layer from the second electrode, thereby improving reliability of the ferroelectric memory cell.

The first electrode, the ferroelectric storage layer, and the composite electrode may be prepared by physical vapor deposition or chemical vapor deposition. Preparation methods for all film layers may be the same or may be different, and may be selected based on actual requirements. In addition, to obtain the ferroelectric storage layer, the preparation method may further include: performing heat treatment on the formed ferroelectric storage layer. A specific heat treatment process may include: heating the formed ferroelectric storage layer until a temperature increases to a first temperature, and then rapidly cooling down the ferroelectric storage layer to a second temperature, where the first temperature is higher than the second temperature. Through heating and cooling, the ferroelectric storage layer can exhibit ferroelectric performance, thereby implementing a function of the ferroelectric memory cell. The first temperature and the second temperature may be selected based on a material for preparing the ferroelectric storage layer. This is not limited herein. In addition, the heat treatment process may be performed after the ferroelectric storage layer is formed and before the composite electrode is formed, or may be performed after the composite electrode is formed, or may be performed after any layer in the composite electrode is formed, provided that the ferroelectric storage layer can exhibit ferroelectric performance. Duration for performing the heat treatment is not limited herein.

For example, when a storage solution provided in embodiments of this application is applied to a storage capacitor, and the storage capacitor is of a three-dimensional structure, forming the first electrode may specifically include: forming the first electrode and an insulation layer that are alternately provided, to obtain a stacked structure; and forming a through hole in the stacked structure, where the through hole passes through the stacked structure in a stacking direction, so that the subsequently prepared ferroelectric storage layer and composite electrode can be formed in the through hole, to obtain the storage capacitor of the three-dimensional structure. A material for preparing the insulation layer may be any material that can provide an insulation function. This is not limited herein.

It should be understood that a principle for the ferroelectric memory cell, prepared according to the preparation method, to resolve the problem is similar to a principle for the ferroelectric memory cell to resolve the problem. Therefore, for embodiments and technical effects of the preparation method, refer to the embodiments and technical effects of the foregoing ferroelectric memory cell, and details are not repeated herein.

According to a third aspect, an embodiment of this application further provides a ferroelectric memory. The ferroelectric memory may include: a storage array and a controller coupled to the storage array. The storage array includes a plurality of ferroelectric memory cells described in the first aspect and any possible implementations of the first aspect. The plurality of ferroelectric memory cells are deployed in an array. The storage array is configured to store data. The controller is configured to write data into the storage array or read data from the storage array. In this way, based on the ferroelectric memory cell with reduced retention loss and weakened imprint effect, the ferroelectric memory also has reduced retention loss and weakened imprint effect, thereby improving performance of the ferroelectric memory. A principle for the ferroelectric memory to resolve the problem is similar to a principle for the ferroelectric memory cell to resolve the problem. Therefore, for embodiments and technical effects of the ferroelectric memory, refer to the embodiments and technical effects of the foregoing ferroelectric memory cell, and details are not repeated herein.

For example, when the ferroelectric memory cell includes a transistor and at least one storage capacitor, the ferroelectric memory may further include a word line, a bit line, and at least one control line. When the ferroelectric memory cells in the storage array are deployed in an array, ferroelectric memory cells located in a same row may be connected to a same word line, and ferroelectric memory cells in different rows are connected to different word lines, so that different word lines can control transistors in different rows of ferroelectric memory cells to be turned on or turned off. Ferroelectric memory cells located in a same column may be connected to a same bit line, and ferroelectric memory cells in different columns are connected to different bit lines, so that different bit lines can provide voltages for different rows of ferroelectric memory cells. Each control line is connected to a second end of each storage capacitor of each ferroelectric memory cell. In other words, each ferroelectric memory cell is connected to each control line, and the control line and the storage capacitor in the ferroelectric memory cell are configured in a same quantity and are disposed in a one-to-one correspondence. Therefore, each ferroelectric memory cell can be precisely controlled by using the word line and the bit line, and precise data writing and reading can be implemented under the effect of a voltage provided by each control line.

According to a fourth aspect, an embodiment of this application further provides an electronic device. The electronic device may include: a circuit board and the ferroelectric memory described in the second aspect and any possible implementation of the second aspect, where the ferroelectric memory is disposed on the circuit board. In this way, based on the ferroelectric memory with improved performance, the electronic device also has performance improved. A principle for the electronic device to resolve the problem is similar to a principle for the ferroelectric memory to resolve the problem. Therefore, for embodiments and technical effects of the electronic device, refer to the embodiments and technical effects of the foregoing ferroelectric memory, and details are not repeated herein.

### BRIEF DESCRIPTION OF DRAWINGS

FIG. 1 is a diagram of a structure of an electronic device according to an embodiment of this application;
FIG. 2 is a diagram of a structure of a ferroelectric memory according to an embodiment of this application;
FIG. 3 is a diagram of a structure of a ferroelectric memory cell according to an embodiment of this application;
FIG. 4 is a diagram of a principle according to an embodiment of this application;
FIG. 5 is a diagram of a structure of another ferroelectric memory cell according to an embodiment of this application;
FIG. 6 is a diagram of a structure of still another ferroelectric memory cell according to an embodiment of this application;
FIG. 7 is a diagram of a structure of yet still another ferroelectric memory cell according to an embodiment of this application;
FIG. 8 is a schematic flowchart of preparing a ferroelectric memory cell according to an embodiment of this application;
FIG. 9 is a schematic flowchart of preparing another ferroelectric memory cell according to an embodiment of this application; and
FIG. 10 is a schematic flowchart of preparing still another ferroelectric memory cell according to an embodiment of this application.

### DESCRIPTION OF EMBODIMENTS

To make the objectives, technical solutions, and advantages of this application clearer, the following further describes this application in detail with reference to the accompanying drawings.

It should be noted that same reference numerals in the accompanying drawings of this application denote same or similar structures. Therefore, repeated descriptions thereof are omitted. Expressions of positions and directions in this application are described by using the accompanying drawings as examples. However, changes may also be made as required, and all the changes fall within the protection scope of this application. The accompanying drawings in this application are merely used to illustrate relative position relationships and do not represent an actual scale.

To facilitate understanding of the technical solutions provided in embodiments of this application, the following first describes application scenarios provided in embodiments of this application.

A storage solution provided in embodiments of this application may be widely applied to a device with a storage function, for example, may be applied to a storage device with only a storage function, such as a ferroelectric memory, or may be applied to an electronic device with a storage function and another function (for example, a read/write function). The electronic device may be a portable electronic device that has functions of a personal digital assistant, a music player, and/or the like, such as a mobile phone, a tablet computer, a wearable device with a wireless communication function (for example, a smartwatch), or an on-board device. An example of an embodiment of the portable electronic device includes but is not limited to a portable electronic device using iOS^{®}, Android^{®}, Microsoft^{®}, or another operating system. The portable electronic device may alternatively be, for example, a laptop computer (Laptop) with a touch-sensitive surface (for example, a touch panel). It should be further understood that, in some other embodiments of this application, the electronic device may alternatively be a desktop computer with a touch-sensitive surface (for example, a touch panel).

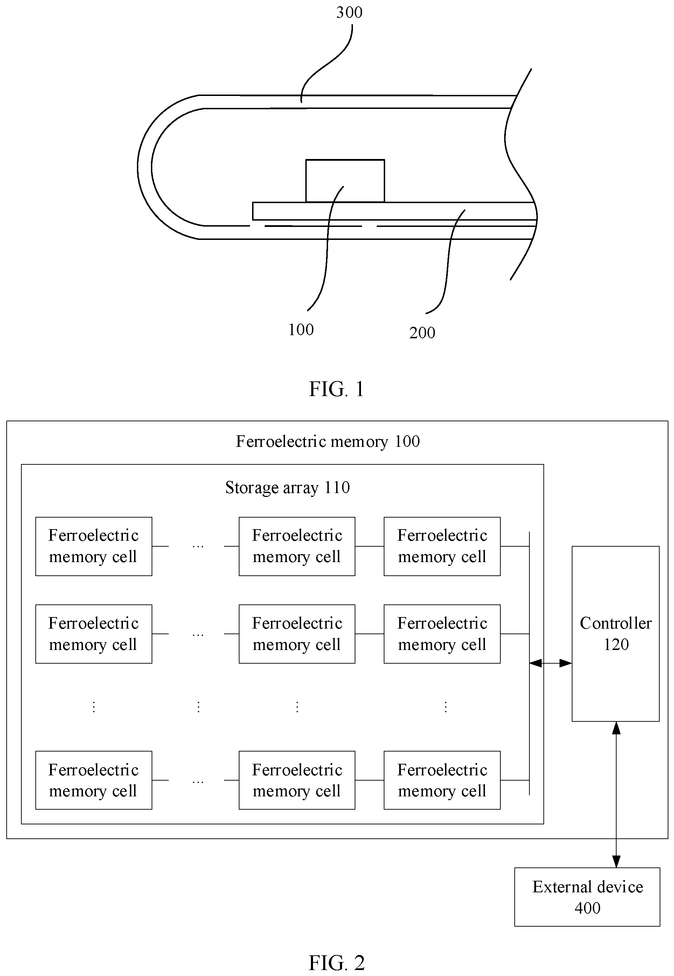

FIG. 1 is a diagram of a structure of an example of a ferroelectric memory used in an electronic device. Refer to FIG. 1. The electronic device includes a housing 300 and a circuit board 200 disposed in the housing 300, and a ferroelectric memory 100 is disposed on the circuit board 200. The ferroelectric memory 100 may be a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. It should be noted that the memory described in this application is intended to include but is not limited to these memories and any memory of another appropriate type.

FIG. 2 is a diagram of an internal structure of an example of the ferroelectric memory 100 to which embodiments of this application are applicable. It should be understood that the ferroelectric memory 100 shown in the figure is merely an example, and the ferroelectric memory 100 may have more or fewer components than those shown in the figure, or may combine two or more components, or may have different component configurations. Various components shown in the figure may be implemented by using hardware including one or more signal processing and/or application-specific integrated circuits, software, or a combination of hardware and software.

As shown in FIG. 2, the ferroelectric memory 100 may include a storage array 110 and a controller 120. The storage array 110 is configured to store data and is a matrix array formed by arranging a plurality of ferroelectric memory cells in rows and columns. Each ferroelectric memory cell can be configured to store one or more bits of binary data, for example, "0" and/or "1". The plurality of ferroelectric memory cells may be located on different tracks of a same disk, or may be located on different disks. This is not specifically limited. The controller 120 is configured to perform a read operation or a write operation on data in the storage array 110, and is a component with a control capability. The controller 120 may be connected to the storage array 110 in a connection manner, for example, by a bus. The controller 120 may include a plurality of functional components, for example, including but not limited to a drive circuit, a decoding circuit, and an amplifier circuit. These functional components may be separately disposed as independent components, or may be implemented in one component, or may be disposed in at least two components in any combination. This is not specifically limited.

Still refer to FIG. 2. The controller 120 may be further connected to an external device 400, and the external device 400 may be, for example, a read and write device or a processor. When reading/writing data, the external device 400 may send a read/write request to the controller 120, where the read/write request carries row address information and column address information of a target ferroelectric memory cell in which the data is to be read/written. The controller 120 decodes the row address information in the read/write request to determine a row in which the target ferroelectric memory cell is located, enables, based on a decoding selection signal, all ferroelectric memory cells corresponding to the row in which the target ferroelectric memory cell is located, decodes the column address information in the read/write request to obtain a column in which the target ferroelectric memory cell is located, reads data stored in the target ferroelectric memory cell in the column, and then sends the data to the external device 400, or writes to-be-written data sent by the external device 400 into the target ferroelectric memory cell in the column.

The ferroelectric memory 100 may further include other components, although not shown in FIG. 2, such as a memory data register (memory data register, MDR) and a memory address register (memory address register, MAR). Details are not described herein.

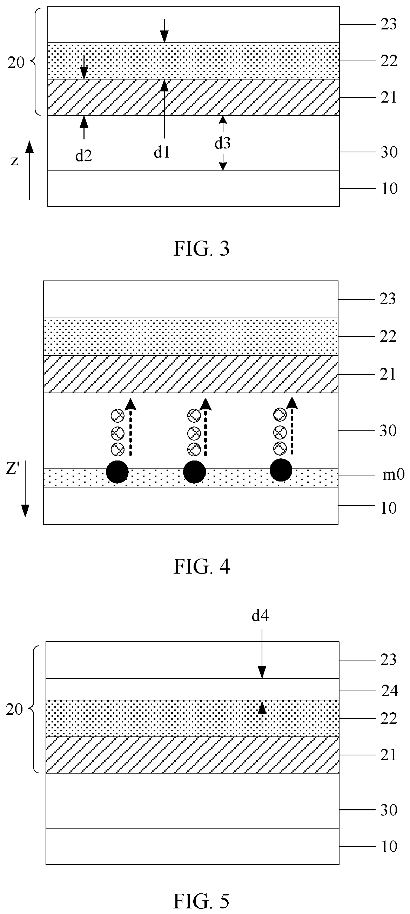

To reduce retention loss in the ferroelectric memory, weaken imprint effect, and improve performance of the ferroelectric memory, an embodiment of this application provides a ferroelectric memory cell. FIG. 3 is a diagram of a structure of an example of a ferroelectric memory cell according to an embodiment of this application. The ferroelectric memory cell may include: a first electrode 10, a composite electrode 20, and a ferroelectric storage layer 30 disposed between the first electrode 10 and the composite electrode 20. The composite electrode 20 includes: a conductive buffer layer 21, a conductive oxygen scavenger layer 22, and a second electrode 23 that are sequentially disposed in a direction from the first electrode 10 to the ferroelectric storage layer 30 (that is, a direction z shown in FIG. 3), where Gibs of an oxide corresponding to the conductive oxygen scavenger layer 22 is less than Gibs of an oxide corresponding to the first electrode 10.

FIG. 4 is a diagram of a principle. Gibs of the oxide corresponding to the conductive oxygen scavenger layer 22 is less than Gibs of the oxide corresponding to the first electrode 10, so that a capability of the conductive oxygen scavenger layer 22 for scavenging oxygen is higher than a capability of the first electrode 10 for scavenging oxygen. In this way, the conductive oxygen scavenger layer 22 can scavenge oxygen (as shown by a black circle in FIG. 4) in an oxide layer m0 formed between the first electrode 10 and the ferroelectric storage layer 30. In addition, an oxygen vacancy (as shown by a grid-filled circle in FIG. 4) in the ferroelectric storage layer 30 can be used as a transport channel for oxygen, to transport oxygen from the oxide layer m0 located between the first electrode 10 and the ferroelectric storage layer 30 to the conductive oxygen scavenger layer 22. A dashed arrow in FIG. 4 indicates that oxygen in the oxide layer m0 migrates upward through the transport channel. In this way, an amount of oxygen in the oxide layer m0 between the first electrode 10 and the ferroelectric storage layer 30 can be reduced, so that a thickness of the oxide layer m0 can be reduced, and further formation of the oxide layer m0 can be suppressed. Because the oxide layer m0 weakens retention and imprint effect, thinning the oxide layer m0 can avoid deterioration of the retention, thereby reducing retention loss, and can further weaken the imprint effect, thereby improving performance of the ferroelectric memory cell. In addition, the conductive buffer layer 21 can avoid direct contact between the conductive oxygen scavenger layer 22 and the ferroelectric storage layer 30, so that scavenging of oxygen in the ferroelectric storage layer 30 by the conductive oxygen scavenger layer 22 during direct contact is avoided, thereby avoiding failure or reduction of scavenging of oxygen in the oxide layer m0. Moreover, because an oxide formed in the conductive oxygen scavenger layer 22 after oxygen scavenging has high oxygen solubility and a positive Gibs change value, the conductive oxygen scavenger layer 22 can well scavenge oxygen in the oxide layer m0 between the first electrode 10 and the ferroelectric storage layer 30. Further, because the conductive oxygen scavenger layer 22 can scavenge oxygen in the oxide layer m0 between the first electrode 10 and the ferroelectric storage layer 30, and the oxygen vacancy in the ferroelectric storage layer 30 can be used as a transport channel for oxygen, oxygen vacancies in the ferroelectric storage layer 30 migrate to the oxide, adjusting a distribution gradient of the oxygen vacancies in the ferroelectric storage layer 30. In this case, density of the oxygen vacancies in the ferroelectric storage layer 30 gradually increases in a direction from the composite electrode 20 to the first electrode 10 (a direction indicated by z' in FIG. 4). In this way, further formation of the oxide layer m0 between the first electrode 10 and the ferroelectric storage layer 30 can also be suppressed. Certainly, the first electrode 10 can achieve specific chemical decomposition effect on the oxide layer m0. This effect can also suppress further formation of the oxide layer m0, thereby further improving performance of the ferroelectric memory cell.

In this ferroelectric memory cell, a material for preparing the conductive oxygen scavenger layer 22 may include at least one of yttrium, titanium, lanthanum, scandium, copper, aluminum, tantalum, and hafnium. Certainly, another material that can implement the conductive oxygen scavenger layer 22 is also suitable in embodiments of this application. In addition, a thickness (as shown by d1 in FIG. 3) of the conductive oxygen scavenger layer 22 may be set to 0.5 nm to 5 nm. In this case, when the thickness of the oxide layer m0 is reduced, a large thickness of the entire ferroelectric memory cell can be further avoided, so that an increase in a volume of the ferroelectric memory cell can be avoided. A material for preparing the conductive buffer layer 21 may include at least one of TiN and TaN. Certainly, another material that can implement a function of the conductive buffer layer 21 is also suitable in embodiments of this application. In addition, a thickness (as shown by d2 in FIG. 3) of the conductive buffer layer 21 may be set to 1 nm to 20 nm. In this case, direct contact between the conductive oxygen scavenger layer 22 and the ferroelectric storage layer 30 can be avoided, and a large thickness of the entire ferroelectric memory cell can also be avoided. A material for preparing the second electrode 23 includes a conductive material, and the conductive material does not include an oxygen element. In this way, the conductive oxygen scavenger layer 22 can fully scavenge oxygen in the oxide layer m0 between the first electrode 10 and the ferroelectric storage layer 30, to maximize reduction of a thickness of the oxide layer m0. In addition, a thickness of the first electrode 10 may be set to 1 nm to 100 nm, and a thickness of the second electrode 23 may be set to 30 nm to 100 nm, so that the first electrode 10 and the second electrode 23 can bear an external force, facilitating formation of a ferroelectric phase in the ferroelectric storage layer 30.

A material for preparing the ferroelectric storage layer 30 may be a doped hafnium oxide material. For example, the material for preparing the ferroelectric storage layer 30 may include: zirconium-doped hafnium oxide (for example, Hf_{0.5}Zr_{0.5}O₂), zirconium- and lanthanum-doped hafnium oxide (for example, La-doped Hf_{0.5}Zr_{0.5}O₂), zirconium- and yttrium-doped hafnium oxide (for example, Y-doped Hf_{0.5}Zr_{0.5}O₂), zirconium- and strontium-doped hafnium oxide (for example, Sr-doped Hf_{0.5}Zr_{0.5}O₂), zirconium- and gadolinium-doped hafnium oxide (for example, Gd-doped Hf_{0.5}Zr_{0.5}O₂), zirconium-, gadolinium-, and lanthanum-doped hafnium oxide (for example, Gd and La co-doped Hf_{0.5}Zr_{0.5}O₂), silicon-doped hafnium oxide (for example, Si-doped HfO₂), aluminum-doped hafnium oxide, lanthanum-doped hafnium oxide, yttrium-doped hafnium oxide, gadolinium-doped hafnium oxide, strontium-doped hafnium oxide, and the like. In addition, a thickness of the ferroelectric storage layer 30 (as shown by d3 in FIG. 3) may be set to 1 nm to 100 nm. Setting the thickness of the ferroelectric storage layer 30 to be in an appropriate range can facilitate formation of a ferroelectric phase, avoiding failure of formation of the ferroelectric phase due to an excessively large thickness of the ferroelectric storage layer 30, and can also avoid a large thickness of the entire ferroelectric memory cell, thereby avoiding an increase in a volume of the ferroelectric memory cell.

The first electrode 10 may be made of a conductive metal, metal oxide, or metal nitride, or another material, and the first electrode 10 may include one or more metal elements. When the first electrode 10 includes a plurality of metals, Gibs of the oxide corresponding to the conductive oxygen scavenger layer 22 is less than Gibs of the oxide corresponding to each metal included in the first electrode 10. In this way, the conductive oxygen scavenger layer 22 can scavenge oxygen in the oxide corresponding to each metal in the first electrode 10, thereby reducing a thickness of the oxide between the first electrode 10 and the ferroelectric storage layer 30, further improving retention and weakening imprint effect, and improving performance of the ferroelectric memory cell.

For example, the ferroelectric memory cell may include a transistor and a storage capacitor. A storage solution provided in embodiments of this application may be applied to the storage capacitor, that is, the first electrode 10, the ferroelectric storage layer 30, and the composite electrode 20 may form the storage capacitor. In addition, when the ferroelectric memory cell is disposed on a substrate, the first electrode 10, the ferroelectric storage layer 30, and the composite electrode 20 may be stacked in a direction perpendicular to a surface of the substrate, and the ferroelectric storage layer 30 is disposed between the first electrode 10 and the composite electrode 20. In this case, the storage capacitor may be considered as a storage capacitor of a two-dimensional structure.

FIG. 5 is a diagram of a structure of an example of a memory cell according to an embodiment of this application. As shown in FIG. 5, the ferroelectric memory cell in this embodiment and the ferroelectric memory cell in the foregoing first embodiment have substantially similar structures, but differ in a structure of the composite electrode 20. For example, the composite electrode 20 may further include a conductive adhesion layer 24 disposed between the conductive oxygen scavenger layer 22 and the second electrode 23. The conductive adhesion layer 24 can increase adhesion strength between the conductive oxygen scavenger layer 22 and the second electrode 23, and avoid detachment of the conductive oxygen scavenger layer 22 from the second electrode 23, thereby improving reliability of the ferroelectric memory cell. A material for preparing the conductive adhesion layer 24 may include at least one of TiN and TaN. Certainly, another material that can implement a function of the conductive adhesion layer 24 is also suitable in embodiments of this application. In addition, a thickness d4 of the conductive adhesion layer 24 may be set to 1 nm to 20 nm. Setting the thickness of the conductive adhesion layer 24 to be in an appropriate range can increase adhesion strength between the conductive oxygen scavenger layer 22 and the second electrode 23, and can also avoid a large thickness of the entire ferroelectric memory cell, thereby avoiding an increase in a volume of the ferroelectric memory cell.

It should be understood that, for similarities between the structures of the ferroelectric memory cell in this embodiment and the ferroelectric memory cell in the foregoing first embodiment, refer to the foregoing first embodiment, and details are not repeated herein.

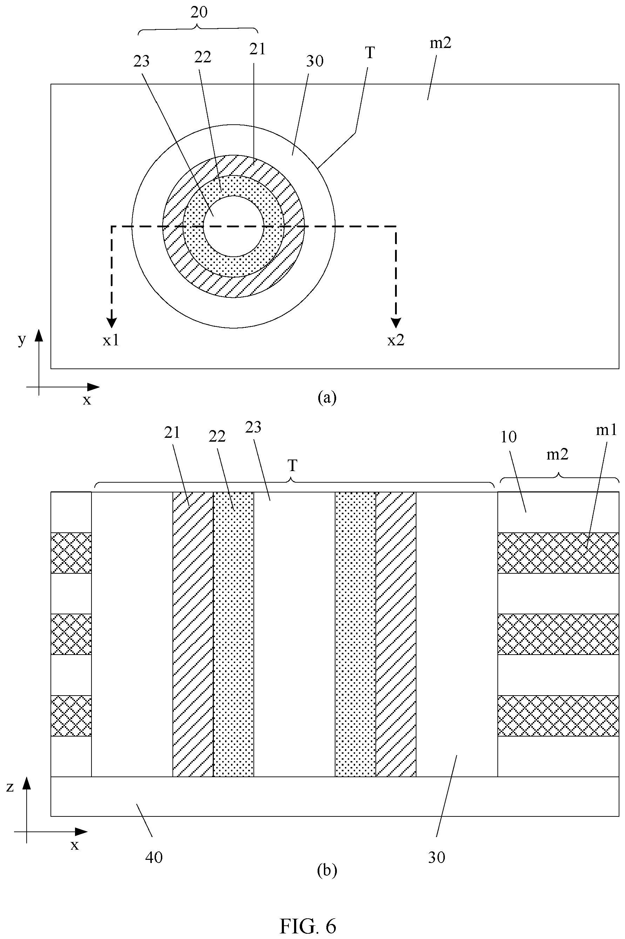

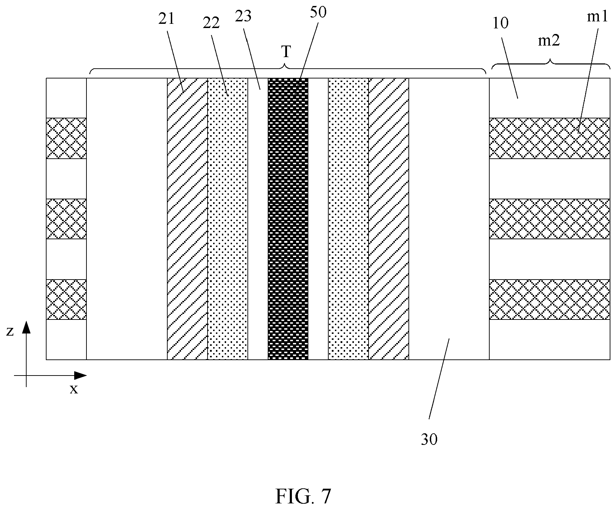

FIG. 6 is a diagram of a structure of an example of a memory cell according to an embodiment of this application. As shown in FIG. 6, (b) is a cross-sectional view in a direction X1-X2 in (a). The ferroelectric memory cell in this embodiment has a structure that is substantially similar to that of the ferroelectric memory cell in the foregoing first embodiment, but differs in a storage capacitor of a three-dimensional structure. For example, the first electrode 10 and an insulation layer m1 may be alternately stacked in a direction perpendicular to a surface of the substrate 40 (a direction z shown in FIG. 6) to form a stacked structure m2, then a through hole T is made in the stacked structure m2, where the through hole T passes through the stacked structure m2 in a stacking direction (the direction z shown in FIG. 6), and then the through hole T is filled sequentially with the ferroelectric storage layer 30 and the composite electrode 20, where the ferroelectric storage layer 30 is disposed between the stacked structure m2 and the composite electrode 20. In this case, a stacking direction (a direction x or direction y shown in FIG. 6) of the conductive buffer layer 21, the conductive oxygen scavenger layer 22, and the second electrode 23 in the composite electrode 20 is perpendicular to an extension direction (the direction z shown in FIG. 6) of the through hole T, so that the formed storage capacitor may be considered as a storage capacitor of a three-dimensional structure. Therefore, the ferroelectric memory cell may be of a two-dimensional structure or a three-dimensional structure, expanding an application scope of the ferroelectric memory cell. In addition, refer to FIG. 7. FIG. 7 is another cross-sectional view in the direction X1-X2 in (a) in FIG. 6. The through hole T may be filled up with the ferroelectric storage layer 30, the composite electrode 20, and a filling layer 50, and the filling layer 50 is disposed on a side that is of the composite electrode 20 and that faces away from the ferroelectric storage layer 30, that is, the filling layer 50 is located on a side that is of the second electrode 23 and that faces away from the conductive oxygen scavenger layer 22. The filling layer 50 may be made of an insulation material. In this way, a material for preparing the composite electrode 20 can be reduced, so that preparation costs of the ferroelectric memory cell can be effectively reduced when the material for preparing the composite electrode 20 has high costs and a material for preparing the filling layer 50 has low costs. Alternatively, as shown in FIG. 6, the through hole T may be filled up with the ferroelectric storage layer 30 and the composite electrode 20, that is, space that is not occupied by the ferroelectric storage layer 30 and that is in the through hole T is filled up with the composite electrode 20. In this way, preparation steps and preparation processes of the ferroelectric memory cell can be simplified, improving preparation efficiency.

It should be understood that, for similarities between the structures of the ferroelectric memory cell in this embodiment and the ferroelectric memory cell in the foregoing first embodiment, refer to the foregoing first embodiment, and details are not repeated herein.

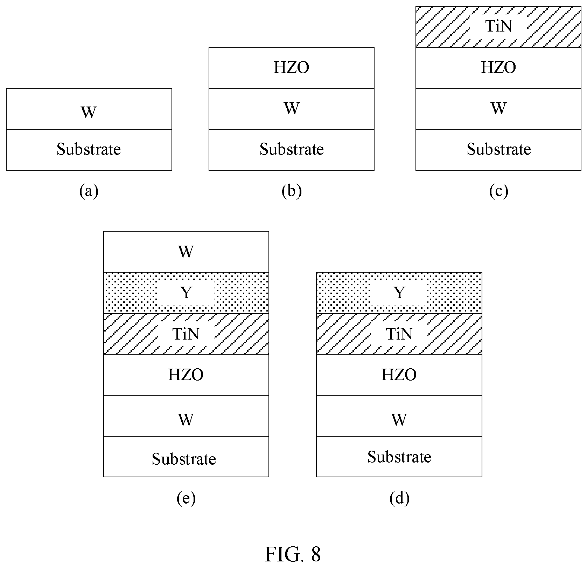

FIG. 8 is a diagram of an example of a first method for preparing a ferroelectric memory cell according to an embodiment of this application. This embodiment is provided by using an example in which the method is applied to a storage capacitor and the storage capacitor is of a two-dimensional structure. As shown in FIG. 8, a specific preparation process of the ferroelectric memory cell may include the following steps.

Step 1: As shown in (a) in FIG. 8, deposit a W film layer with a thickness of about 50 nm on a substrate by chemical vapor deposition, to form a first electrode, where the W film layer is made of, but not limited to, a metal W.

Step 2: As shown in (b) in FIG. 8, deposit an HZO layer with a thickness of about 10 nm on the first electrode by atomic layer deposition, to form a ferroelectric storage layer, where the HZO layer is made of, but not limited to, a zirconium-doped hafnium oxide material.

In the zirconium-doped hafnium oxide material, a molar ratio of zirconium to hafnium is 1:1, but is not limited to 1:1. This is merely an example for description.

Step 3: As shown in (c) in FIG. 8, deposit a TiN layer with a thickness of about 5 nm on the ferroelectric storage layer by atomic layer deposition, to form a conductive buffer layer, where the TiN layer is made of, but not limited to, TiN.

Step 4: As shown in (d) in FIG. 8, deposit a Y film layer with a thickness of about 3 nm on the conductive buffer layer by physical vapor deposition, to form a conductive oxygen scavenger layer, where the Y film layer is made of, but not limited to, a metal Y (Chinese name: yttrium). In this case, Gibbs free energy of an oxide corresponding (that is, yttrium oxide) to the conductive oxygen scavenger layer is less than Gibbs free energy of an oxide (that is, tungsten oxide) corresponding to the first electrode.

Step 5: As shown in (e) in FIG. 8, deposit a W film layer with a thickness of about 50 nm on the conductive oxygen scavenger layer by chemical vapor deposition, to form a second electrode, where the W film layer is made of, but not limited to, a metal W. In this case, the conductive buffer layer, the conductive oxygen scavenger layer, and the second electrode form a composite electrode.

Step 6: Perform heat treatment on a structure obtained in step 5, for the ferroelectric storage layer to exhibit ferroelectric performance.

It should be understood that, in step 1 to step 5, the used preparation materials and the thickness of each film layer are not limited to the cases listed in this embodiment. This is merely an example for description. Specifically, another preparation material and another thickness of the film layer may be selected based on an actual requirement. This is not limited herein. In addition, the thickness of each film layer shown in FIG. 8 does not represent a thickness of an actually prepared film layer, but only represents a position relationship between the film layers, and does not represent a dimension of an actual film layer.

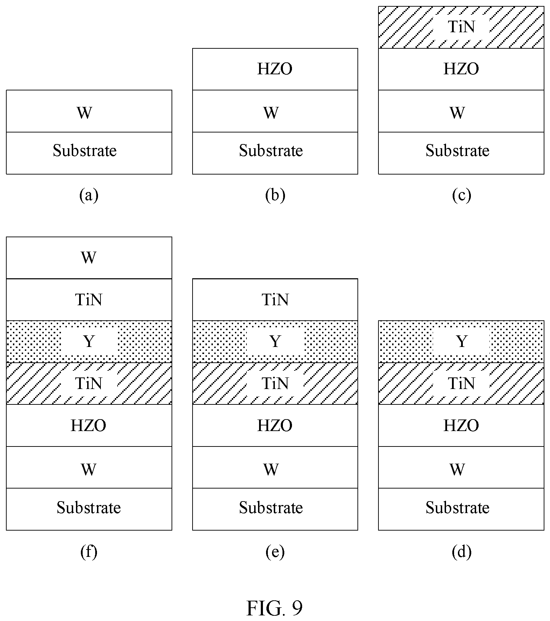

FIG. 9 is a diagram of an example of a second method for preparing a ferroelectric memory cell according to an embodiment of this application. As shown in FIG. 9, the second preparation method in this embodiment is substantially similar to the first preparation method in the foregoing embodiment, but differs in that step s1 is added between step 4 and step 5. Specifically, step s1 may include: as shown in (e) in FIG. 9, depositing a TiN layer with a thickness of about 5 nm on the conductive oxygen scavenger layer by atomic layer deposition, to form a conductive adhesion layer, where the TiN layer is made of, but not limited to, TiN. The conductive adhesion layer can increase adhesion strength between the conductive oxygen scavenger layer and the second electrode, and avoid detachment of the conductive oxygen scavenger layer from the second electrode, thereby improving reliability of the ferroelectric memory cell. Further, step 5 in the foregoing embodiment may be adaptively adjusted as follows: As shown in (f) in FIG. 9, a W film layer with a thickness of about 50 nm is deposited on the conductive adhesion layer by chemical vapor deposition, to form a second electrode, where the W film layer is made of, but not limited to, a metal W. In this case, the conductive buffer layer, the conductive oxygen scavenger layer, the conductive adhesion layer, and the second electrode form a composite electrode.

It should be understood that (a) in FIG. 9 in this embodiment is the same as (a) in FIG. 8 in the foregoing embodiment, (b) in FIG. 9 in this embodiment is the same as (b) in FIG. 8 in the foregoing embodiment, (c) in FIG. 9 in this embodiment is the same as (c) in FIG. 8 in the foregoing embodiment, and (d) in FIG. 9 in this embodiment is the same as (d) in FIG. 8 in the foregoing embodiment. Therefore, for similarities between the second preparation method in this embodiment and the first preparation method in the foregoing embodiment, refer to the first preparation method in the foregoing embodiment, and details are not repeated herein.

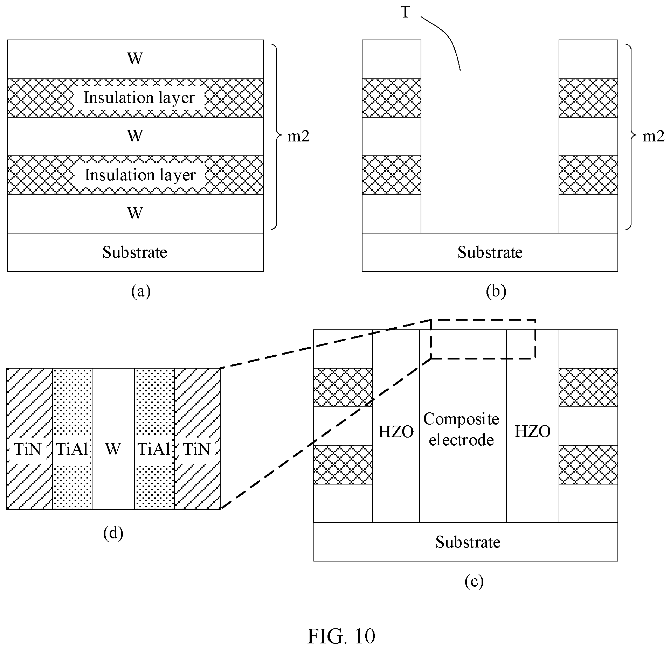

FIG. 10 is a diagram of an example of a third method for preparing a ferroelectric memory cell according to an embodiment of this application. As shown in FIG. 10, the third preparation method in this embodiment is substantially similar to the first preparation method in the foregoing embodiment, but differs in the following:
(1) Step 1 is adjusted as follows: As shown in (a) in FIG. 10, a metal W film layer and an insulation layer are deposited alternately on a substrate by chemical vapor deposition, to obtain a stacked structure m2, where the metal W film layer is used as a first electrode, and the stacked structure m2 includes a plurality of first electrodes and a plurality of insulation layers.
(2) Step s2 is added between step 1 and step 2, and step s2 may include: as shown in (b) in FIG. 10, making a hole in the stacked structure m2 by photoetching and dry etching with a high depth-to-width ratio, to obtain a columnar through hole T with a diameter of about 50 nm, where the through hole T passes through the stacked structure m2 in a stacking direction.
(3) All the film layers formed in step 2 to step 5 are prepared in the through hole T, as shown in (c) and (d) in FIG. 10.
(4) The material for preparing the conductive oxygen scavenger layer in step 4 is adjusted to a titanium-aluminum alloy, that is, TiAl.
(5) If the remaining space in the through hole T is not filled up with the second electrode formed in step 5, a filling layer needs to be further formed after the second electrode is formed, and the unoccupied space in the through hole T is filled up with the filling layer. This is not shown in the figure. A process of preparing the filling layer includes: depositing an insulation layer m1, made of an insulation material, on the second electrode by chemical vapor deposition, to fill up the through hole T. The insulation material may be the same as or different from the material for preparing the insulation layer m1.

In this way, an obtained storage capacitor is of a three-dimensional structure, expanding an application scope of the ferroelectric memory cell.

It should be understood that, for similarities between the third preparation method in this embodiment and the first preparation method in the foregoing embodiment, refer to the first preparation method in the foregoing embodiment, and details are not repeated herein.

Clearly, a person skilled in the art can make various modifications and variations to embodiments of this application without departing from the spirit and scope of embodiments of this application. In this case, this application is intended to cover these modifications and variations of embodiments of this application provided that they fall within the scope of the claims of this application and their equivalent technologies.

## Claims

1. A ferroelectric memory cell, comprising: a first electrode, a composite electrode, and a ferroelectric storage layer disposed between the first electrode and the composite electrode, wherein the composite electrode comprises a conductive buffer layer, a conductive oxygen scavenger layer, and a second electrode that are sequentially disposed in a direction from the first electrode to the ferroelectric storage layer, wherein Gibbs free energy of an oxide corresponding to the conductive oxygen scavenger layer is less than Gibbs free energy of an oxide corresponding to the first electrode.

2. The ferroelectric memory cell according to claim 1, wherein a material for preparing the conductive buffer layer comprises at least one of TiN and TaN.

3. The ferroelectric memory cell according to claim 1 or 2, wherein a thickness of the conductive buffer layer is 1 nm to 20 nm.

4. The ferroelectric memory cell according to any one of claims 1 to 3, wherein a material for preparing the conductive oxygen scavenger layer comprises at least one of yttrium, titanium, lanthanum, scandium, copper, aluminum, tantalum, and hafnium.

5. The ferroelectric memory cell according to any one of claims 1 to 4, wherein a thickness of the conductive oxygen scavenger layer is 0.5 nm to 5 nm.

6. The ferroelectric memory cell according to any one of claims 1 to 5, wherein a thickness of the second electrode is 30 nm to 100 nm.

7. The ferroelectric memory cell according to any one of claims 1 to 6, wherein a material for preparing the second electrode comprises a conductive material, and the conductive material does not comprise an oxygen element.

8. The ferroelectric memory cell according to any one of claims 1 to 7, wherein the composite electrode further comprises a conductive adhesion layer disposed between the conductive oxygen scavenger layer and the second electrode.

9. The ferroelectric memory cell according to claim 8, wherein a material for preparing the conductive adhesion layer comprises at least one of TiN and TaN.

10. A method for preparing the ferroelectric memory cell according to any one of claims 1 to 9, comprising:
forming the first electrode;
forming the ferroelectric storage layer on the first electrode;
forming the conductive buffer layer on the ferroelectric storage layer;
forming the conductive oxygen scavenger layer on the conductive buffer layer, wherein the Gibbs free energy of the oxide corresponding to the conductive oxygen scavenger layer is less than the Gibbs free energy of the oxide corresponding to the first electrode; and
forming the second electrode on the conductive oxygen scavenger layer, for the conductive buffer layer, the conductive oxygen scavenger layer, and the second electrode to form the composite electrode.

11. The method according to claim 10, further comprising:
forming the conductive adhesion layer on the conductive oxygen scavenger layer after forming the conductive oxygen scavenger layer and before forming the second electrode.

12. A ferroelectric memory, comprising: a storage array and a controller coupled to the storage array, wherein the storage array comprises a plurality of ferroelectric memory cells according to any one of claims 1 to 9, and the plurality of ferroelectric memory cells are deployed in an array;
the storage array is configured to store data; and
the controller is configured to write data into the storage array or read data from the storage array.

13. An electronic device, comprising: a circuit board and the ferroelectric memory according to claim 12, wherein the ferroelectric memory is disposed on the circuit board.
